Europäisches Patentamt

European Patent Office

Office européen des brevets

(19)

(11) Publication number: **0 230 348**
A2

# EUROPEAN PATENT APPLICATION

(21) Application number: **87300110.1**

(51) Int. Cl.⁴: **G 01 R 1/073**

(22) Date of filing: **07.01.87**

(30) Priority: **07.01.86 US 816666**

(43) Date of publication of application: **29.07.87**
Bulletin 87/31

(84) Designated Contracting States: **DE FR GB**

(72) Inventor: **Garrettson, Garrett A., P.O. Box 10301, Palo Alto California 94303-0890 (US)**
Inventor: **Chao, Clinton C., P.O. Box 10301, Palo Alto California 94303-0890 (US)**
Inventor: **Neukermans, Armand P., P.O. Box 10301, Palo Alto California 94303-0890 (US)**
Inventor: **Leslie, Brian C., P.O. Box 10301, Palo Alto California 94303-0890 (US)**
Inventor: **Foster, Jack D., P.O. Box 10301, Palo Alto California 94303-0890 (US)**
Inventor: **Greenstein, Michael, P.O. Box 10301, Palo Alto California 94303-0890 (US)**
Inventor: **Matta, Farid, P.O. Box 10301, Palo Alto California 94303-0890 (US)**
Inventor: **Joly, Robert, P.O. Box 10301, Palo Alto California 94303-0890 (US)**

(71) Applicant: **Hewlett-Packard Company, Mail Stop 20 B-O 3000 Hanover Street, Palo Alto California 94304 (US)**

(74) Representative: **Williams, John Francis et al, J.F. Williams & Co 34 Tavistock Street, London WC2E 7PB (GB)**

(54) **Test probe.**

(57) A test probe for integrated circuits is presented. This probe has a flexible membrane with leads and contacts formed with lithographic techniques. The leads can be formed to minimize voltage reflections and crosstalk. Also, termination devices can be added near the device under test in order to match the impedance of the device under test. This combination facilitates the testing of high density integrated circuits at high frequencies while the circuits are still on the wafer. Also, high density substrates for multi-chip carriers can be tested with this probe.

Test Probe

This invention relates to a test probe for making contact with a plurality of input/output pads of an integrated circuit to be tested.

Prior art integrated circuit test probes have several significant limitations. They access a limited number of input/output pads on integrated circuits and they use low frequency signals for testing the integrated circuits. Prior-art integrated circuit test probes have typically individual tungsten wires for each input/output pad on an integrated circuit. The sharp points on the end of the test wires dig into the input/output pads on the integrated circuit in order to make a low impedance electrical contact. These prior-art test probes work well when integrated circuits contain less than one hundred input/output pads. However, prior art test probes containing more than 150 test point wires have proven to be unwieldy and impractical. They are difficult and expensive to fabricate, susceptible to shorts and damage, and prone to undesired capacitive coupling between the probes. In addition, prior-art test probes cause deterioration of signal quality. Capacitive coupling between the test point wires introduces crosstalk. Mismatched impedance causes reflections in the signals. The high inductance of the test point wires limits the bandwidth.

Advances in integrated circuit technology have produced integrated circuits with testing requirements that clearly exceed what the prior-art test probes can deliver. Integrated circuits may contain more than 150 input/output pads. In addition, these pads may be located all over the surface of the chip, not just around the perimeter. Therefore, test probes for these chips must contain a corresponding number of test wires arranged to probe the entire surface of the chip.

Integrated circuits operate at speeds up to 100 MHz or more. Prior-art test probes severely distort such high frequency signals. This deficiency restricts testing to low frequency signals, and means that testing at operational speed must be deferred until the device is packaged. The packaging typically costs three to four times the amount of the integrated circuit itself, so discarding a faulty integrated circuit at this point is costly. The cost burden becomes even more oppressive when the integrated circuit is mounted on a multi-chip carrier using surface mounting techniques. A surface mounted device cannot generally be tested until it is integrated into a second level package such as a multi-chip carrier with other surface mounted devices. Failures detected at this point result in expensive reworking. To avoid this, integrated circuits, to be mounted as surface mounted devices, should be tested at their operating speed on the water.

Accordingly , the invention propose a test probe for making contact with multiple contact points of an integrated circuit, having a plurality of contacts on a contact member, each contact being connected by a lead to an output terminal, wherein the contact member is a flexible membrane carrying a plurality of leads connected to a plurality of contact pads, and in that deflection means are provided for the flexible membrane.

Such a test probe is capable of accessing thousands of input/output pads on an integrated circuit, and can also conduct high frequency tests on pre-packaged

0230348

3

integrated circuits. Preferably, the invention uses integrated circuit lithography to construct leads and contact pads on the flexible membrane. This invention provides versatile, relatively inexpensive and accurate contact to hundreds or thousands of input/output pads on an integrated circuit. Since the density of contact pads on the test probe is limited only by integrated circuit lithography techniques, the contact pad density of the test probe can always correspond to the transistor density of the integrated circuits.

There are several advantages to forming the leads and contact pads with integrated circuit lithographic techniques. Integrated circuit lithographic technology can place contact pads accurately and in complex patterns. Also, the leads which connect to the contact pads can be formed as transmission lines meeting exact specifications. Transmission line parameters can be chosen to reduce signal or voltage reflection between the leads and the tester's driving circuitry and also to reduce crosstalk between adjacent leads.

The flexible membrane has several advantages. Impedance matching devices and bypass capacitors can be located closer to the device under test (DUT). Also, the flexible membrane can deform to compensate for the lack of coplanarity between the DUT and the test probe. The input impedance of the DUT can vary significantly from the output impedance of the leads and the tester's driving circuitry. This can be remedied by a impedance matching device located near the DUT. This will minimize distortion and maximize power transfer between the transmission line and the DUT. The flexible membrane also permits a power line bypass capacitor to be located near the DUT. The proximity of these capacitors to the DUT provides a minimum inductance path between the DUT and the capacitor which stabilizes the voltage of the power supply.

Pressure applied to the flexible membrane forces the contact pads against the input/output pads of the DUT. The pressure is applied by a spring device such as a polymeric spring. The dimensions of the polymeric spring are chosen to induce a scrubbing action between the contact pads of the flexible membrane and the input/output pads of the DUT when the contact pads are forced against the DUT. The contact pads of the flexible membrane can be a hard, non-oxidizing conductor or an electroplated contact coated with a hard conductor if desired.

The invention also provides a method of making a test probe comprising the steps of: providing a conductor pattern on one surface of a flexible membrane; providing a plurality of contact pads at appropriate spacings and each in contact with a conductor of said pattern; mounting said membrane in a frame; causing said conductor pattern to contact a further conductor pattern leading to output terminals on said frame.

Further, the invention provides a method of conducting tests on integrated circuits comprising bringing a flexible membrane carrying a conductor pattern into registration with an integrated circuit to be tested; clamping the membrane in relation to the integrated circuit; and causing pressure to be applied between contact pads of said conductor pattern and contact points of the integrated circuit, during which the membrane deflects.

The test probe invention can be used to test the high-density substrates of multi-chip carriers. These

5

substrates contain thousands of leads and contact pads. Money and time can be spared by testing these substrates before integrated circuits are installed on them. Thus the DUT may be an integrated circuit, substrate of a multi-chip carrier, or other device with a multiplicity of input/output pads.

The drawings illustrate a number of exemplary embodiments of the invention. In these:

Figure 1 shows a sectional view of a first embodiment of the invention;

Figure 2 shows a top view of the embodiment of the invention as shown in Figure 1, partially cut away;

Figure 3 shows an enlarged cut-away view of part of the flexible membrane shown in Figure 1;

Figure 4A shows a side view of the flexible membrane before leads and contacts are formed on it.

Figure 4B shows a top view of the flexible membrane shown in Figure 4A after leads and contacts have been formed on it.

Figure 5A shows a sectional view of Figure 4B after the ground shield has been formed on it.

Figure 5B shows the membrane as in Figure 5A with the holes drilled through the membrane for the contact pads.

Figure 5C shows the membrane as in Figure 5B with the contact pads plated in.

Figure 6A shows the membrane as in Figure 5C with the surface mounted device added.

Figure 6B shows the mounted membrane as shown in Figure 6A clamped to the printed circuit board frame.

Figure 7 shows an alternate embodiment of the invention with balls used as contact pads and with a pneumatic spring.

Figure 8A and Figure 8B show an alternative embodiment of the flexible membrane shown in Figure 4B with the membrane thinned around the leads and contact pads.

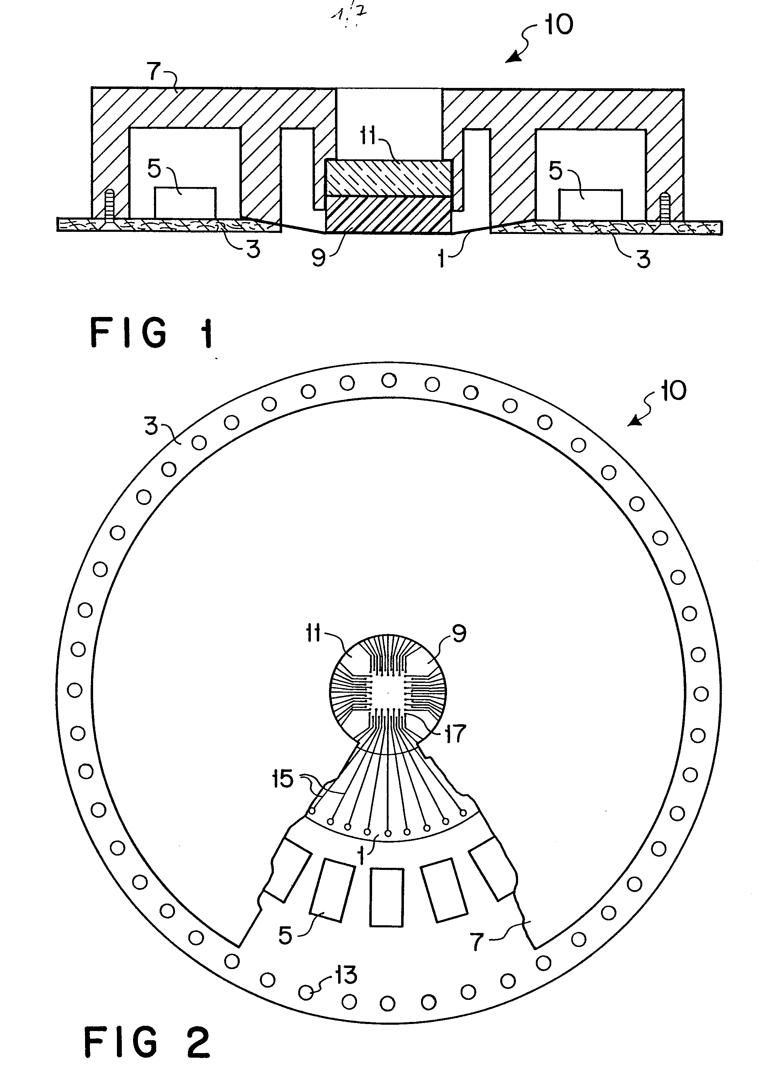

Figure 1 is a section through a test probe 10, in which flexible membrane 1 is clamped to a printed circuit board 3 by a clamp 7. The clamp 7 also guides a polymeric spring 9 against flexible membrane 1. Surface mounted devices 5 used for example to match the impedance between the device under test, DUT (not shown) and leads 15 are mounted on the printed circuit board 3. However, the surface mounted devices 5 could also be mounted on the flexible membrane 1.

Figure 2 is a top view of the test probe 10. The printed circuit board 3 in the preferred embodiment is annular. External contact pads 13 along the perimeter facilitate the mounting of the test probe 10 in a testing instrument. The clamp 7 which holds the membrane on the printed circuit board is annular in shape. The clamp 7 has an opening in the centre to allow alignment of the test probe 10 with the DUT. The cut away, drawing of the clamp 7 in Figure 2 exposes the flexible membrane 1. The flexible membrane 1 is a transparent dielectric film 21. The polymeric spring 9 and the window 11 are also transparent. This facilitates the alignment of the test probe 10 with the DUT.

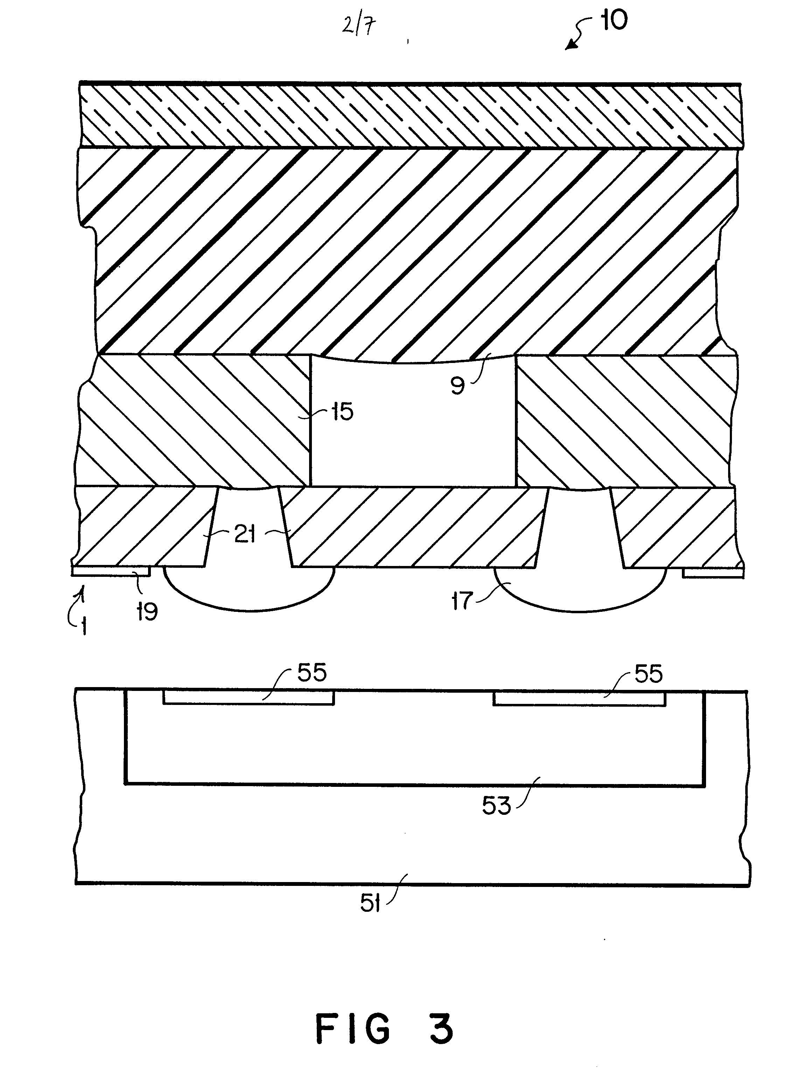

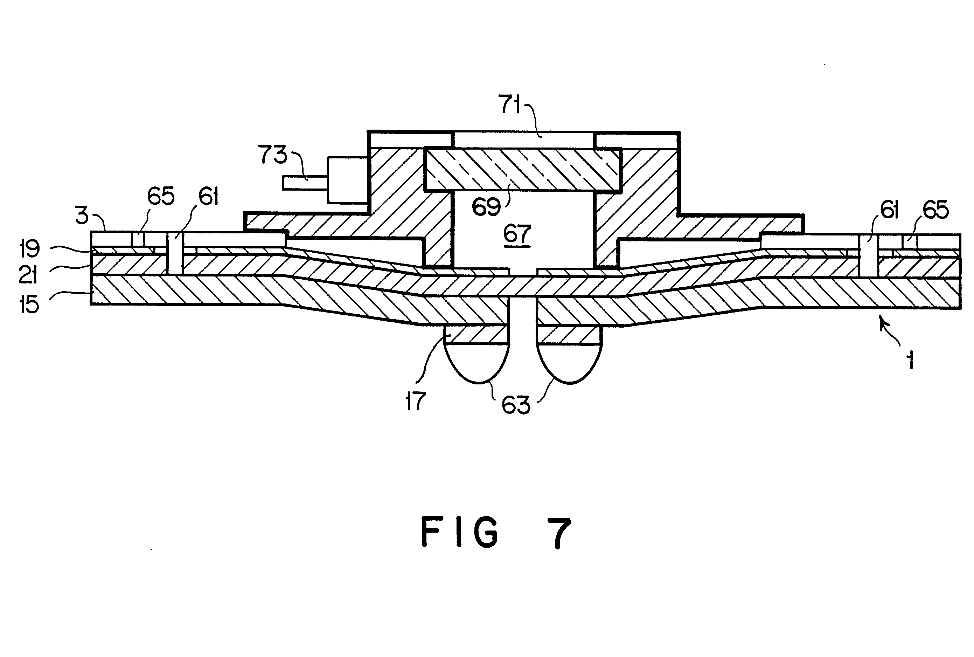

Leads 15 on the flexible membrane 1 conduct signals to and from the DUT through contact pads 17 (Fig.3). Contact pads may be formed by attaching a contact to a lead 15 by soldering, as shown in Figure 7, or the contact pad 17 can be formed by a plating process.

Figure 3 is an enlarged drawing of the flexible membrane 1. The leads 15 are on a dielectric film 21. A ground (earth) plane 19 is located on the other side of the dielectric membrane 21 from the leads 15. To facilitate the alignment of the test probe 10 with the DUT 53, the ground plane 19 does not cover the dielectric membrane 21 underneath the polymeric spring 9 and the window 11. The contact pads 17 shown are formed by a plating process, but could alternatively be formed by evaporation techniques or sputtering techniques and extend through holes in the film 21 to contact the leads 15. The polymeric spring 9 resides on top of the flexible membrane 1 touching the leads 15 mostly and extending into voids slightly. It provides a spring force between the leads 15 and the window 11. In use, the test probe 10 is aligned with a DUT 53 so that the contact pads 17 of the test probe 10 connect with input/output pads 55 of the DUT 53 being tested.

In another embodiment of the invention (not shown), the flexible membrane 1 can have several layers of leads 15 and polyimide films 21. When testing very dense devices with a large number of input/output pads, it may be necessary to have multiple layers of leads 15 and polyimide layers 21 in order to fit all the necessary leads 15 on one flexible membrane 1. In such an embodiment of the invention, the contact pads 17 would be on the outside surface of the flexible membrane 1. In order for contact pads 17 to reach leads several layers away from the surface, holes must be formed through the appropriate layers.

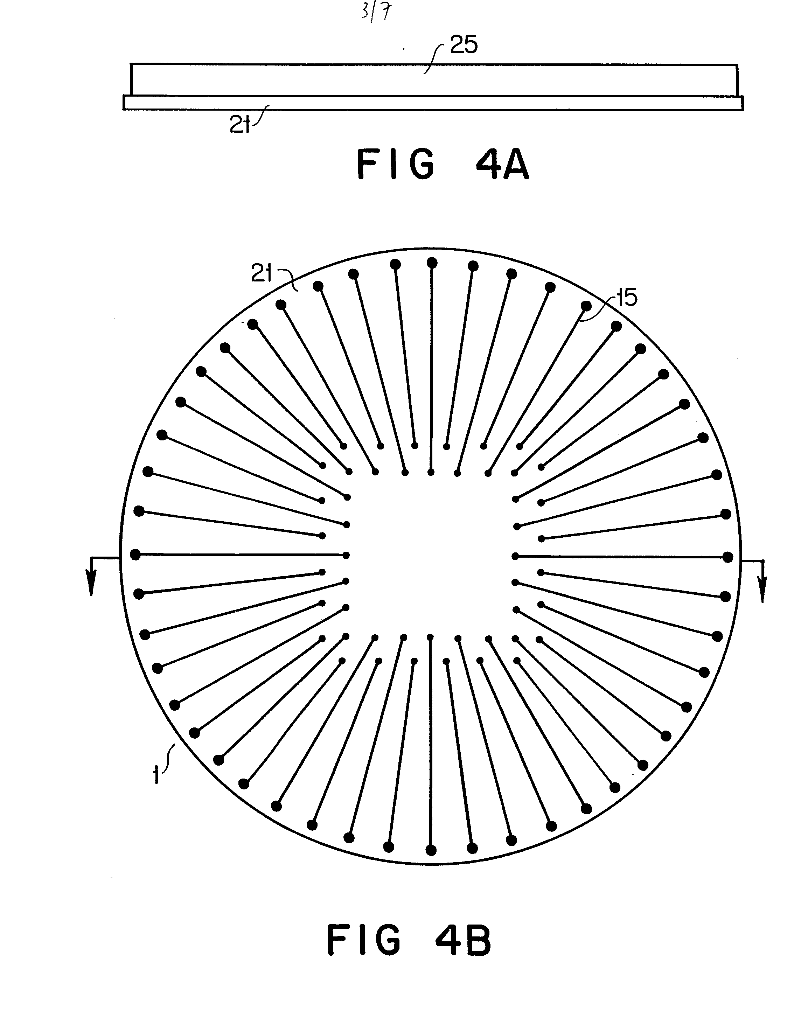

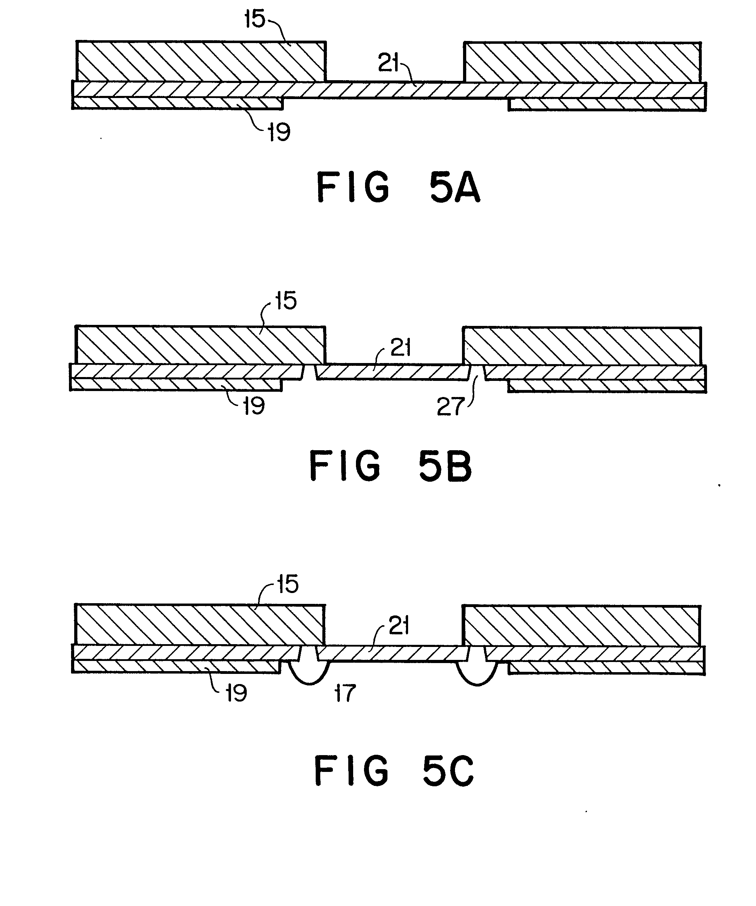

The construction of the test probe 10 comprises several steps as seen in Figures 4 and 5. Figure 4A shows the raw material from which the flexible membrane 1 is formed. This material, which can be purchased from a variety of vendors, has a transparent dielectric layer 21 and a conducting layer 25. In the preferred embodiment, the dielectric layer is made out of polyimide, but many different flexible and insulating materials could be used. Figure 4B shows a top view of the flexible membrane 1 after the leads 15 have been formed. Using lithographic technology, leads 15 are patterned onto the conducting layer 25, and appropriate areas etched away, for example. After the leads 15 are formed, a ground plane 19 is deposited onto the reverse surface of the polyimide layer 21 as shown in Figure 5A. A variety of techniques can be used to form the ground plane 19, including a sputtering technique. Additional shielding for the leads 15 can be obtained by constructing grounded conductors on either side of the leads 15. To form the contact pads 17, holes 27 are drilled through the polyimide layer 21 as shown in Figure 5B. The holes 27 are drilled, for example, by laser milling. These holes 17 are then filled by plating as shown in Figure 5C to form the contact pads 17. Multi-layer, flexible membranes 1 are constructed in a similar manner.

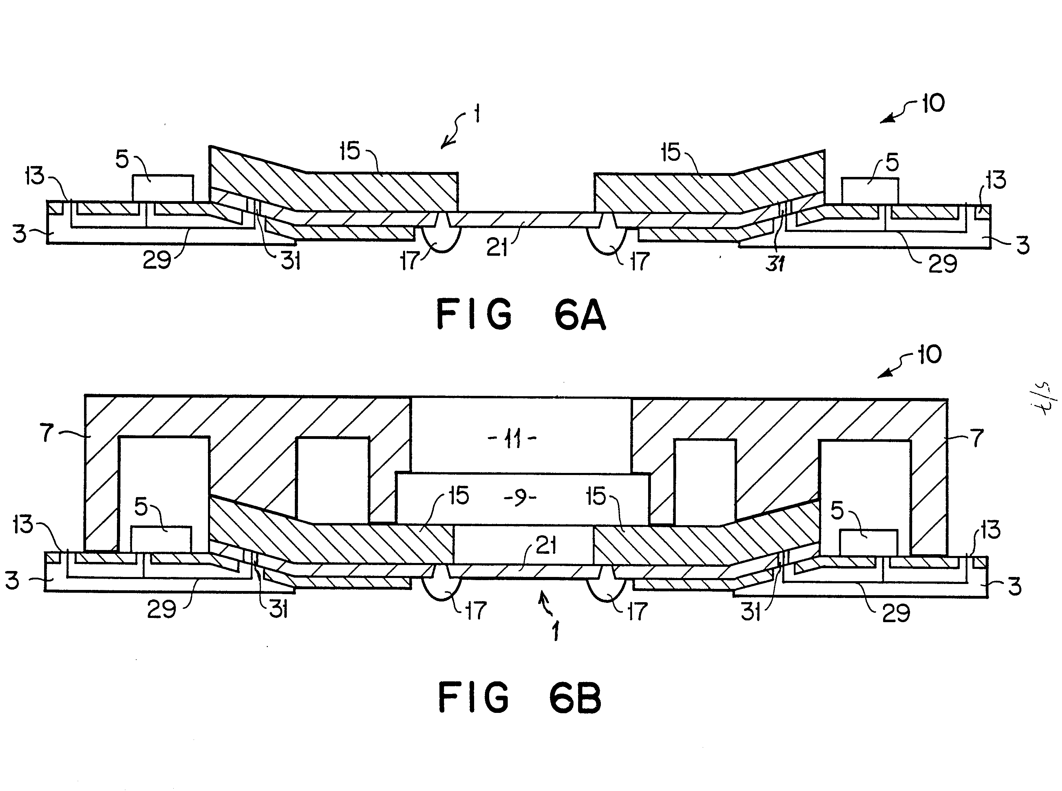

The flexible membrane 1 is then connected to a multilayer printed circuit board 3 as shown in Figure 6A. The leads 15 are connected to their respective circuit board conductors 29 in the printed circuit board 3. The connection is formed by drilling holes 31 through the polyimide layer 21 and filling these holes with a conducting material. The circuit board conductors 29 are connected to an external contact pad 13 to which the tester connects. Surface mounted devices 5 are placed on printed circuit board 3 and connected to the circuit board conductor 29 which connects to the leads 15. The test probe contact pads 17 scrub the surface of the input/output pads 55 when forced onto them. This feature, designed into the test probe 10, removes the oxide and dirt from the input/output pads 55 so that good electrical contact is formed between them. Features of the flexible membrane 1 and the polymeric spring 9 produce the scrubbing action. The strain parameter of the polyimide layer 21 is chosen so that the contact pads 17 will be forced sideways as they are pushed down on the input/output pads 55. Also, the parameters of the polymeric spring 9 are chosen so that it pushes the contact pads 17 sideways as it pushes the polymeric spring 9 down.

Next, a clamp 7 fastens the printed circuit board 3 and the flexible membrane 1 together as shown in Figure 6B to form a low impedance connection between lead 15 and the printed circuit board conductor 29.

The last step in construction of the test probe 10 adds the polymeric spring 9 and the transparent window 11 shown in Figure 1. The combination of the hole in the centre of the clamp 7, the window 11, the transparent polymeric spring 9, and the transparent polyimide layer 21 permits one to visually align the contact pads 17 with the input/output pads 55 of the DUT 51.

Figure 7 shows an alternative embodiment of the invention. In this embodiment the leads 15 are on the bottom side of the flexible membrane 1. The contact pads 17 have one half of a ball 63 attached to them. The ball 63 is constructed from a hard conductor which does not oxidize,. such as tungsten carbide. Another set of holes 61 are drilled through the polyimide layer 21, ground shield 19, and printed circuit board 3 to bring the signals from lead 15 to the top surface of the printed circuit board 3 to facilitate connection to the tester. The other set of holes 65 connect the ground shield 19 to the top side of the printed circuit board 3. The balls 63 are forced against the DUT by pressure from a sealed chamber 67.

The sealed chamber 67 can be filled with a gas or with a liquid which is then pressurized to deflect the flexible membrane 1 outward. This pressurization can occur by the addition of gas or a liquid through a nozzle 73. When the sealed chamber 67 is filled with a liquid, pressurization can be obtained by moving a wall of the chamber 67 inward. Since liquids are incompressible, the flexible membrane 1 will be forced outwards. The alignment windows 69 and 71 are transparent so that the contact pads 17 can be aligned with the input/output pads of the DUT.

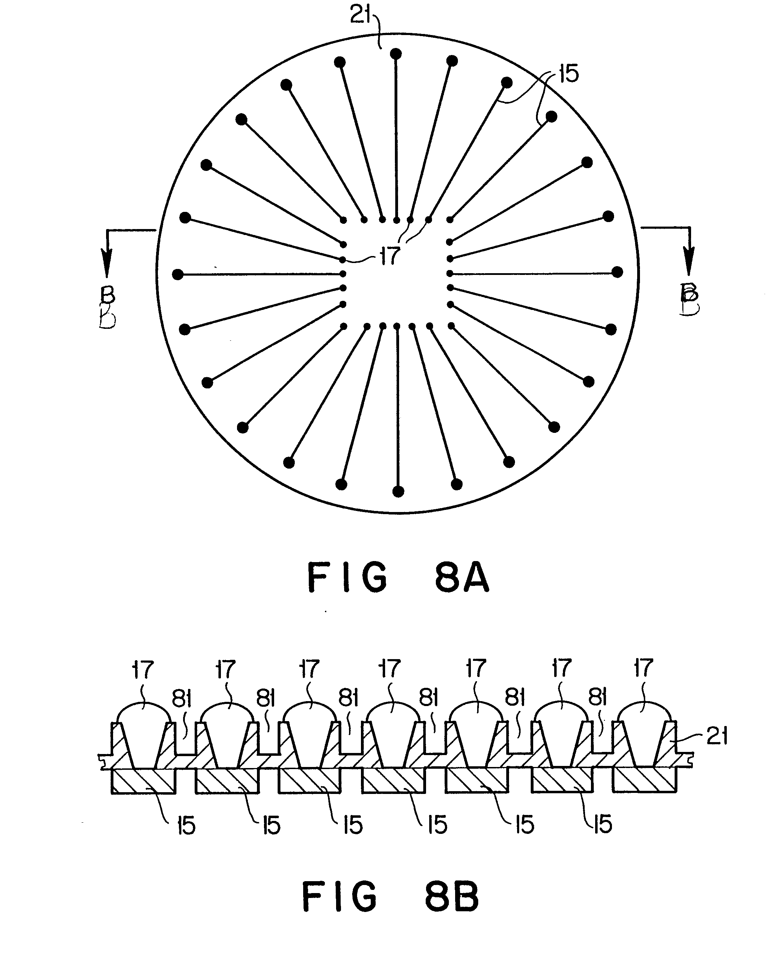

In order to obtain increased flexibility of the membrane 1, areas 81 can be selectively thinned by using a laser milling process. Figure 8B shows a section on B-B in Figure 8A. A laser removes parts 81 of the flexible membrane 1 near the contact pads 17 and leads 15.

When using a test probe 10 to test an integrated circuit, the following steps are done. The contact pads 17 are constructed on the flexible membrane 1 to match the input/output pads 55 of the DUT 53. The test probe 10 is assembled with the flexible membrane 1. The test probe 10 is connected to a tester through the external contact pads 13. The test probe 10 is aligned with the DUT 53 so that the contact pads 17 on the flexible membrane 1 are aligned with the input/output pads 55 on the DUT 53. The test probe 10 is lowered onto the DUT 53. Tester conducts tests. The test probe 10 is removed from the DUT 53.

## Claims

1. A test probe for making contact with multiple contact points of an integrated circuit, having a plurality of contacts on a contact member, each contact being connected by a lead to an output terminal, wherein the contact member is a flexible membrane (1) carrying a plurality of leads (15) connected to a plurality of contact pads (17), and in that deflection means (9, 67) are provided for the flexible membrane (1).

2. A test probe as claimed in Claim 1, wherein shielding means for said leads is located adjacent to said leads.

3. A test probe as claimed in Claim 2, wherein said shielding means comprises a first grounded layer located adjacent to said flexible membrane and near said leads.

4. A test probe as claimed in Claim 2, wherein said shielding means further comprises a plurality of grounded conducting strips located adjacent to said leads.

5. A test probe as claimed in any preceding claim, wherein said leads (15) and/or components (5) connected thereto electrically modify signals passed to from the contact pads (17).

6. A test probe as claimed in any preceding claim wherein said contact pads (17) have a semi-spherical shape.

7. A test probe as claimed in any preceding claim, wherein the contact pads (17) are formed by a deposition technique, such as electroplating, evaporation, or sputtering.

8. A test probe as claimed in any preceding claim, wherein said flexible membrane (1) is mounted in a frame (7).

9. A test probe as claimed in any preceding claim, wherein said deflection means comprises a polymeric spring located adjacent to said flexible membrane.

10. A test probe as claimed in any of Claims 1 to 8, wherein said deflection means comprises an enclosure having said flexible membrane forming a wall thereof.

11. A test probe as claimed in Claim 10, wherein said enclosure can be pressurized to deflect said flexible membrane.

12. A test probe as claimed in Claim 11, wherein another wall of said enclosure can be moved to produce pressurization causing said flexible membrane to deflect.

13. A test probe as claimed in any preceding claim, wherein said flexible membrane has reduced thickness adjacent to said contact pads.

14

14. A method of making a test probe comprising the steps of: providing a conductor pattern on one surface of a flexible membrane; providing a plurality of contact pads at appropriate spacings and each in contact with a conductor of said pattern; mounting said membrane in a frame; causing said conductor pattern to contact a further conductor pattern leading to output terminals on said frame.

15. A method of conducting tests on integrated circuits comprising bringing a flexible membrane carrying a conductor pattern into registration with an integrated circuit to be tested; clamping the membrane in relation to the integrated circuit; and causing pressure to be applied between contact pads of said conductor pattern and contact points of the integrated circuit, during which the membrane deflects.

16. A method as claimed in Claim 15, wherein with deflection of the membrane the contact pads scrub across the contact points to ensure a good electrical contact.

17. A method as claimed in Claim 15 or 16, wherein the pressure is applied by a fluid medium in a chamber bounded by the membrane.

0230348

FIG 1

FIG 2

FIG 3

25

21

# FIG 4A

21

15

1

# FIG 4B

4/7

FIG 5A

FIG 5B

FIG 5C

FIG 6A

FIG 6B

0230348

FIG 7

7/7

FIG 8A

FIG 8B